(19) Europäisches Patentamt
European Patent Office
Office européen des brevets

(11) **EP 1 378 756 B1**

(12) **EUROPEAN PATENT SPECIFICATION**

(45) Date of publication and mention
of the grant of the patent:
**15.08.2007 Bulletin 2007/33**

(51) Int Cl.:
***G01R 21/133*** *(2006.01)*

(21) Application number: **03468003.3**

(22) Date of filing: **02.07.2003**

(54) **Digital circuit for measuring of power**

Digitale Schaltung zur Leistungsmessung

Circuit numérique de mesure de la puissance

(84) Designated Contracting States:
**AT BE BG CH CY CZ DE DK EE ES FI FR GB GR HU IE IT LI LU MC NL PT RO SE SI SK TR**

(30) Priority: **02.07.2002 SI 200200166**

(43) Date of publication of application:
**07.01.2004 Bulletin 2004/02**

(73) Proprietor: **Iskraemeco, Merjenje in Upravljanje Energije, D.D.**
**4000 Kranj (SI)**

(72) Inventors:
• **Rozman, Miro**
**4248 Lesce (SI)**
• **Strle, Vojko**
**1000 Ljubljana (SI)**
• **Kosmac, Milan**
**4274 Zirovnica (SI)**
• **Solar, Borut**
**4220 Skofja loka (SI)**

(74) Representative: **Gros, Mladen**
**Patentna pisarna d.o.o.**
**Copova 14**
**P.O. Box 1725**
**1001 Ljubljana (SI)**

(56) References cited:
US-A- 5 345 409     US-A- 5 485 393
US-A- 5 736 848     US-A- 6 078 870

## Description

The invention concerns a circuit for generating signals representative of electric power parameters like signals representative of actual power, reactive power, apparent power, normalized value of the electric current intensity, normalized value of electric voltage or phase angle cosine, namely by digitally processing a first input analogue measuring signal in a first form as a signal di/dt representative of a time derivative of the electric current intensity or in a second form as a signal i of the electric current intensity and a second input analogue measuring signal u as a signal representative of the electric voltage, wherein the input analogue measuring signals are conducted to the inputs of two first order $\Sigma$-$\Delta$ modulators and thereby one-bit data streams corresponding to two input analogue measuring signals are delivered. The circuit of the invention is a uniform circuit for generating signals of all electric power parameters and is appropriate for large scale integration in the sub-micrometer technology.

Complex processing of input analogue measuring signals in a large scale integrated circuit produced in sub-micrometer technology is rather expensive. Analogue functions as compared to digital ones need a large processing area. Therefore, first the analogue-to-digital conversion has to be performed and thereafter digital signals have to be processed.

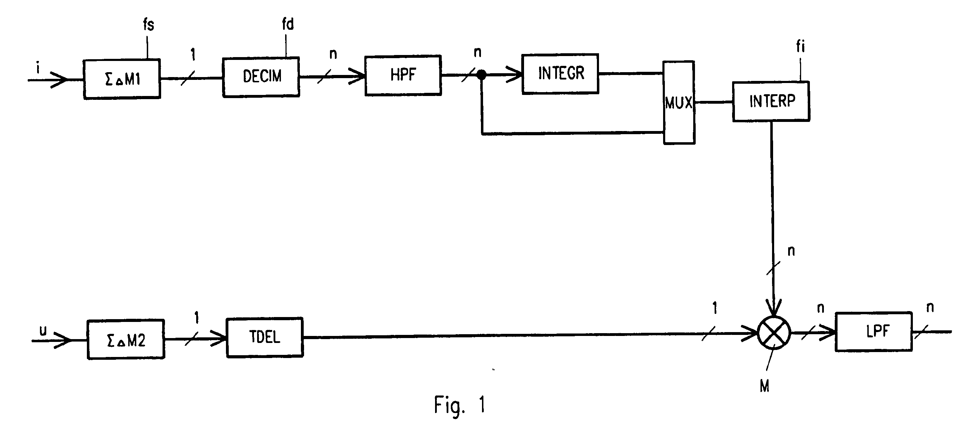

The patent US 5,862,069 and similarly also in the patents US 6,278,392 and EP 0 681 235 A3 discloses a circuit for a multiplication of two time dependent analogue signals without any restriction with regard to their signs. Two second order $\Sigma$-$\Delta$ modulators $\Sigma\Delta$M1, $\Sigma\Delta$M2 convert two input analogue signals i, u into corresponding one-bit data streams (Fig. 1). Sampling is performed with a frequency fs. In a first order decimation filter DECIM the first one-bit data stream (in serial form) is converted in a n-bit data stream (in parallel form) with a lower sampling frequency fd. In a high-pass filter HPF a direct-current component is rejected. Through a digital integrator INTEGR with a multiplexer MUX, when the first input analogue signal i as delivered by a sensor - e. g. a Rogowski coil - is tapped as a time derivative of the electric current intensity, and through an interpolator INTERP with a control frequency fi the first data stream is conducted to the first input of a digital multiplier M. To the second input thereof the second data stream from the second $\Sigma$-$\Delta$ modulator $\Sigma\Delta$M2 is conducted, in fact through an element TDEL providing delay in time to compensate the first data stream phase delay in the decimation filter DECIM and the high-pass filter HPF. The product data stream is conducted through a low-pass filter LPF, therefrom rejecting alternating components of the quantization noise and of the ripple. Normally, the digital multiplier M consists of a digital adder adding instantaneous values of the parallel data stream, their polarity being determined by the bit value in the serial data stream. Said technical solution contains systematic errors. Namely, a phase difference due to an asymmetry between the first and second factor branches cannot be completely compensated in a wider frequency range. Said asymmetry causes the circuit to be sensitive to electromagnetic interferences (EMC interferences). Response times of digital filters are so high that they cause delays and prolong measuring times. Additionally, the processing of parallel data streams is complex and requires a more expensive design.

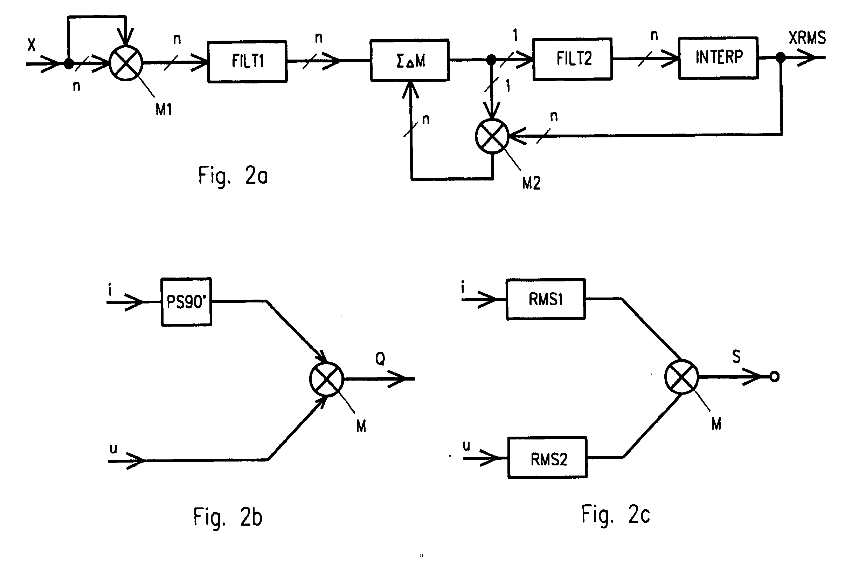

The patent US 6,307,493 discloses a circuit for producing a signal, which is a nonlinear function of an input signal. Fig. 2a shows a circuit for generating the root-mean-square value XRMS from the input parallel form signal X. The input signal X is squared in a multiplier M1 and is conducted through a filter FILT1 to the input of a $\Sigma$-$\Delta$ modulator $\Sigma\Delta$M in a circuit which performs root extracting. The serial signal from the output of the $\Sigma$-$\Delta$ modulator $\Sigma\Delta$M is conducted to the first input of a multiplier M2 at one hand and on the other hand through a filter FILT2, where it is transformed into the parallel form again, and then through an inetrpolator INTERP to the signal XRMS output and to the second input of the multiplier M2, too. The ouput thereof is returned to the $\Sigma$-$\Delta$ modulator $\Sigma\Delta$M. Dynamics of the squared signal is more significant than that of the input signal. To avoid errors at low signal levels a higher resolution in the analogue-to-digital conversion and in the signal processing is needed. Therefore, all assemblies in a circuit of Fig. 2a, i. e. both multipliers and filters as well as $\Sigma$-$\Delta$ modulator and interpolator, have high resolution. In Figs. 2b and 2c, however, circuits for producing a signal Q representative of a reactive power and a signal S representative of an apparent power, respectively, are represented. In the first case, higher harmonic components are generated by an element PS90° to produce a phase shift of 90° and by a multiplier M, in the product signal, however, a ripple is present which must be removed by filtering. In the second case, in the multiplier M effective values produced in circuits RMS1 and RMS2 for generating the root-mean-square value are multiplied, a drawback of which circuits has already been mentioned.

Hereafter technical solutions representing the technological background are described.

The patent US 5,485,393 has disclosed a digital current meter, which includes a current sensor outputing the time derivative of the current. A processor includes a feedforward path, which consists of a second-order $\Sigma\Delta$ modulator, a third-order sinc filter, a delay element, a first-order sinc filter and an infinite impulse response filter, a feedback path, which provides an analog DC error voltage being subtracted from the input signal, and an integrator path. When combined with a voltage meter to measure the power consumption, a half-sample delay is introduced in the current signal path, to compensate for the lead provided by the combination of the analog differentiation and the digital integration.

There has been known an electricity meter provided with a monitoring of measurement channels (US 6,078,870). Signals from an electrical consumer are fed to a multiplexer within each channel and further through a $\Sigma\Delta$ modulator to a common digital signal processing device comparing data of the equivalent signals for generating an error signal.

US patent 5,345,409 discloses a system for processing electrical power signals, which are digitalized by an analog-to-digital conversion using $\Sigma\Delta$ modulators and decimation filters. Alternative embodiments of a circuitry for performing multiplication and of a decimation filter as disclosed in cited references may be used.

There has been known an arrangement, in which an analogue power value is determined, which is converted into digital form by a $\Sigma\Delta$ modulator, a digital filter and an digital quantizig arrangement (US 5,736,848).

The present invention solves the technical problem existing in a proposal of a cheap circuit for digitally processing said input analogue measuring signals so that in real time signals representative of all electric power parameters, like the actual power, reactive power, apparent power, normalized value of electric current intensity and of electric voltage or phase angle cosine, will be available at its outputs.

Novel features considered characteristic of this invention are set forth with particularity in the appended claims.

The circuit for generating signals representative of electric power parameters by digitally processing the input analogue measuring signals achieve the following advantages. By automatic elimination of offset voltages, phase errors and frequency dependencies as well as by elimination of a ripple, appearing in the products of the instantaneous values of input signals, as well as by the proposed novel processing of the signals to produce the signals representative of the actual power and, in the case of a time derivative of the electric current intensity as the first input analogue measuring signal also to produce signals representative of the reactive power, adjustable times of the circuit according to the invention are made possible, which are shorter than one second, which is very appropriate for an automated production of the proposed circuit.

Further advantages are also offered by a novel way of digitally processing the input analogue measuring signals. It makes the application of first order $\Sigma\text{-}\Delta$ modulator possible. The circuit for generating the root-mean-square values, also proposed by the invention and which is a part of the uniform circuit, ensures the same precision, as it is achieved in computing the active power, in the same dynamic range. In the case of a time derivative of the electric current intensity as the first input analogue measuring signal no additional integrator is needed. The signal P representative of the actual power and the signal Q (output C) representative of the reactive power need no low-pass filter.

The invention provides a cheap uniform circuit producing the signals representative of all said electric power parameters by digitally processing the input analogue measuring signals.

The invention will be now explained in more detail by way of the description of two variant embodiments and with reference to the accompanying drawing representing in

| | |
|---|---|
| Figs. 3, 4, 5 and 6, | in a symbolic way, separate digital elements used in circuits of the invention, |
| Fig. 7 | a circuit of the invention to perform time differentiation and decimation, |
| Fig. 8 | a circuit of the invention to perform integration, |
| Fig. 9a and 9b | a circuit of the invention for generating a signal representative of the root-mean-square value for a serial and parallel input signal, respectively, |
| Fig. 10 | a circuit of the invention in the first variant embodiment for generating signals representative of electric power parameters by digitally processing a first input analogue measuring signal in a first form as a signal di/dt representative of a time derivative of the electric current intensity or in a second form as a signal i of the electric current intensity and a second input analogue measuring signal u as a signal representative of the electric voltage and |
| Fig. 11 | a circuit of the invention in the second variant embodiment for generating signals representative of electric power parameters by means of a digital signal processor. |

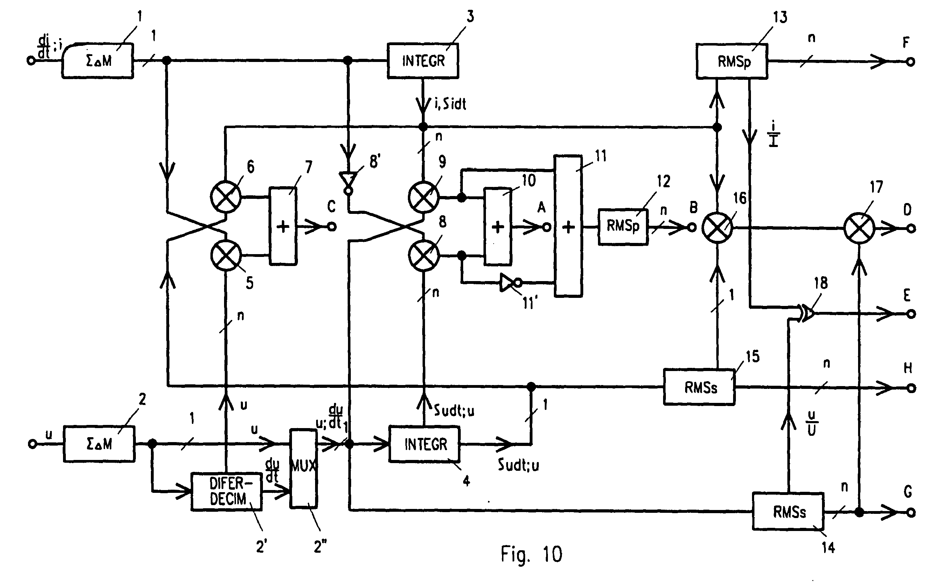

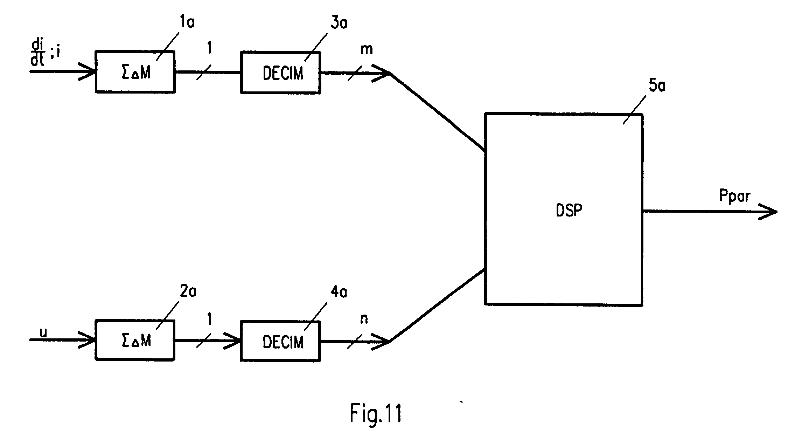

Input analogue measuring signals are digitally processed in both variant embodiments of the invention of a circuit for generating signals representative of electric power parameters, whereby the signals are digitized in analogue-to-digital converters 1, 2; 1a, 2a just at the input of the circuit of the invention (Fig. 10 and 11). First order $\Sigma\text{-}\Delta$ modulators are used as said analogue-to-digital converters 1, 2; 1a, 2a. Sampling frequency ranges between 500 kHz and 10 MHz.

The two input analogue measuring signals are the signal representative of the electric current intensity or of a time derivative thereof - as delivered by a Rogowski coil or inductively coupled coils - and the signal representative of the electric voltage. The circuit of the invention is constructed so that analogue signals as delivered by current or voltage sensors of any kind can be used as input analogue measuring signals.

The first input analogue measuring signal is either in a first form as a signal di/dt representative of a time derivative of the electric current intensity or in a second form as a signal i of the electric current intensity, and the second input analogue measuring signal is a signal u representative of the electric voltage.

S slash on a line in figures marks how a digital data stream - one-bit serial one or n-bit parallel one - flows across that line. In the following description this will be specifically mentioned everywhere where necessary for clarity reasons.

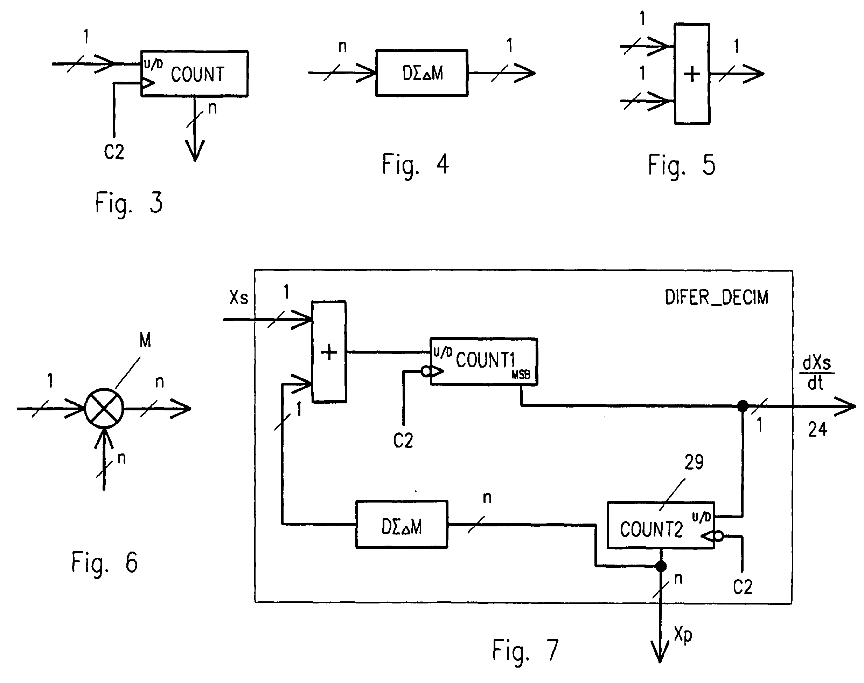

Figs. 3, 4, 5 and 6 represent a schematic view of subunits for digitally processing the digital $\Sigma\text{-}\Delta$ signals. Integration and conversion of an one-bit serial signal in a n-bit parallel one is performed by an up/down counter COUNT having a length n and the clock frequency of which equals to or is higher than the frequency of sampling in the input Σ-Δ modulators 1, 2; 1a, 2a (Fig. 3). A conversion of a n-bit parallel signal to an one-bit serial signal is performed by a digital Σ-Δ modulator DΣΔM (Fig. 4; Gert van der Horn et al., "Integrated Smart Sensors: Design and Calibration", Kluwer Academic Publishers, 1998). Moreover, a digital adder (Fig. 5; P. O'Leary et al., "Bit Stream Adder for Oversampling Coded Data", Electronics Letters, 27, Sept. 1990, vol. 26, No. 20) and a digital multiplier M, constructed as an attenuator (Fig. 6; D. A. Johns et al., "IIR Filtering on Sigma-Delta Modulated Signals", Electronics Letters, 14, Febr. 1991, vol. 27, No. 4), are represented.

In Fig. 10 the circuit of the invention in the first variant embodiment for generating signals representative of electric power parameters is represented. The first input analogue measuring signal is conducted to the input of the first Σ-Δ modulator 1 and the second input analogue measuring signal is conducted to the input of the second E-Δ modulator 2. The Σ-Δ modulators 1 and 2 deliver one-bit serial data streams corresponding to the first and the second input analogue measuring signal, respectively.

One-bit data stream from the output of the second Σ-Δ modulator 2 is conducted to the first input of a multiplexer 2" and to the input of a circuit 2' for time derivating and decimating. The time-drivative output of said circuit 2' is connected to the second input of the multiplexer 2". At the output of the multiplexer 2", in the case of the first input analogue measuring signal in the first form, *i. e.* in a form of a time derivative of the electric current intensity, the data stream is delivered as it is delivered at the output of the second Σ-Δ modulator 2, and, in the case of the first input analogue measuring signal in the second form, *i. e.* in a form of the electric current intensity, at the output of the multiplexer 2" the data stream is delivered as it is delivered at the time-drivative output of the circuit 2' for time derivating and decimating.

The output of the first Σ-Δ modulator 1 is connected to the first input of a first multiplier 5, to the second input of which the decimated data stream output of said circuit 2' for time derivating and decimating is connected. The output of the multiplier 5 is connected to the first input of a first adder 7. The parallel output of a first integrator 3, the input of which is connected to the output of the first Σ-Δ modulator 1, is connected to the first input of a second multiplier 6, to the second input of which the serial output of a second integrator 4 is connected, the input of which is connected to the output of the multiplexer 2". The output of the multiplier 6 is connected to the second input of the first adder 7. In the case of the first input analogue measuring signal in the first form, *i. e.* in the form of a time derivative of the electric current intensity, at the output C of the first adder 7 a signal Q representative of the reactive power appears. In the case of the first input analogue measuring signal in the second form, *i. e.* in the form of the electric current intensity, however, a signal at the output C does not represent any of the electric power parameters.

Through a first inverter 8' the output of the first Σ-Δ modulator 1 is connected to the first input of a third multiplier 8, to the second input whereof the parallel output of the second integrator 4 is connected. The output of the multiplier 8 is connected to the first input of a second adder 10. The parallel output of the first integrator 3 is connected to the first input of a fourth multiplier 9, to the second input of which the output of the multiplexer 2" is connected. The output of the multiplier 9 is connected to the second input of the second adder 10. At the output A thereof an actual power signal P appears.

Through a second inverter 11', however, the output of the third multiplier 8 is connected to the first input of a third adder 11, to the second input of which the output of the fourth multiplier 9 is connected. The output of the adder 11 is connected to the input of a first circuit 12 for generating the root-mean-square value. At the output B of said circuit 12 an apparent power signal S appears.

At the output F of a second circuit 13 for generating the root-mean-square value, the input of which is connected to the parallel output of the first integrator 3, a signal I representative of the root-mean-square value of the electric current intensity appears.

In the case of the first input analogue measuring signal in the first form, at the parallel output G of a third circuit 14 for generating the root-mean-square value, the input of said circuit 14 being connected to the serial output of the multiplexer 2", a signal U representative of the electric voltage root-mean-square value appears.

In the case of the first input analogue measuring signal in the second form, at the parallel output H of a fourth circuit 15 for generating the root-mean-square value, the input of said circuit 15 being connected to the serial output of the second integrator 4, a signal U representative of an electric voltage root-mean-square value appears.

The output of the first integrator 3 is connected to the first input of a fifth multiplier 16, to the second input of which the serial output of the fourth circuit 15 for generating the root-mean-square value is connected and the output of which is connected to the first input of a sixth multiplier 17. To the second input of the multiplier 17 the serial output of the third circuit 14 for generating the root-mean-square value is connected. At the output D of the multiplier 17 a reactive power signal Q appears.

The signal i/I of the normalized value of the current and the signal u/U representative of the normalized value of the voltage delivered from the circuit 13 and 14, respectively, for generating the root-mean-square value are conducted to the inputs of an EXOR gate 18 being a statistical multiplier. At the output E thereof a signal cosΦ representative of the phase angle cosine appears.

In the represented first variant embodiment of the circuit of the invention for generating signals representative of the electric power parameters from both input data streams a signal representative of any of said power parameters is obtained by the digital processing, which may be represented by the following expressions in the case of the first input analogue measuring signal in the first form:

$$P = i \cdot u - \int u \cdot dt \cdot \left( \frac{di}{dt} \right) \qquad (1)$$

$$S = \left( \overline{\left\{ \int \left[ i \cdot u - u \cdot dt \cdot \left( \frac{di}{dt} \right) \right] \right\}^2} \right)^{\frac{1}{2}} \qquad (2)$$

$$Q = K1 \cdot i \cdot \int u \cdot dt + K2 \cdot \left( u \cdot \left( \frac{di}{dt} \right) \right) \qquad (3)$$

$$Q = i \cdot \frac{\int u \cdot dt}{U} \cdot U \qquad (4)$$

$$\cos\phi = \frac{u}{U} \cdot \frac{i}{I} \qquad (5)$$

$$I = \frac{\overline{\int \frac{di}{dt} \cdot dt}}{I} \cdot i \qquad (6)$$

$$U = \frac{\overline{u}}{U} \cdot u \ . \qquad (7)$$

The constants K1 and K2 are adjusted by appropriate selection of amplitudes of the input signals.
In the case of the first input analogue measuring signal in the second form, however, the digital processing of the input data streams may be represented by the following expressions:

$$P = i \cdot u - \int i \cdot dt \cdot \frac{du}{dt} \qquad (1')$$

$$S = \left(\overline{\left\{i \cdot u - i \cdot dt \cdot \frac{du}{dt}\right\}^2}\right)^{\frac{1}{2}} \qquad (2')$$

$$Q = \int i \cdot dt \cdot \frac{u}{U} \cdot \frac{du}{dt} \qquad (4')$$

$$\cos\phi = \frac{\int i \cdot dt}{I} \cdot \frac{\frac{du}{dt}}{U} \qquad (5')$$

$$I = \frac{\overline{i}}{I} \cdot i \qquad (6')$$

$$U = \frac{\overline{u}}{U} \cdot u \quad . \qquad (7)$$

It is well known that in the current-voltage product besides a direct current component also an alternating component - its frequency being twice the power-line frequency - is present. In a very advantageous way the circuit of the invention delivers a time-independent signal P at the output A and a time-independent signal Q at the output C. The signals P and Q, as generated by the circuit of the invention according to the above expressions (1), (1') and (3), respectively, are fully ripple-free.Therefore in a very advantageous way, ouput low-pass filters are not needed at the outputs A and C.

The signals delivered by the circuit of the invention are without an offset voltage of the $\Sigma$-$\Delta$ modulators 1 and 2. Symmetric circuit architecture does not allow any difference in phase between the signals at the outputs of the integrators 3 and 4. Due to the above mentioned facts, exact measurements are made feasible in a very short time in a wide dynamic range of the input analogue measuring signals. The circuit of the invention is advantageously produced in submicrometer technology.

In the above represented circuit according to the first variant embodiment of the invention (Fig. 10) the following, already mentioned subunits, which are also proposed by the invention, are used: the circuit 2' for time derivating and decimating, the integrating circuits 3 and 4, the circuits 14 and 15 for generating the root-mean-square value out of a serial input signal and the circuits 12 and 13 for generating the root-mean-square value out of a parallel input signal.

The circuit 2' for time derivating and decimating is represented in Fig. 7 as a circuit DIFER_DECIM. A serial signal Xs is conducted to the input of this circuit, said input being at the first input of an adder, to the second input of which the output of a digital $\Sigma$-$\Delta$ modulator D$\Sigma\Delta$M is connected and the output of which is connected to the input of a first up/down counter COUNT 1. A clock frequency of this counter is equal to or higher than the frequency of sampling the input signal. The counter functions as a digital comparator comparing two $\Sigma$-$\Delta$ signals and delivering the most important bit at the output of a last counter cell. In order to provide stable operation in case of an overflow, the counter COUNT 1 must be provided with a clipping function. The output thereof is the ouput for a signal dXs/dt, which is representative of the time derivative of the input signal Xs, on the one hand and is connected to the input of a second up/down counter COUNT2 on the other hand. The output thereof is the ouput for a parallel signal Xp, which is representative of the decimated input signal Xs, on the one hand and is connected to the input of the digital $\Sigma$-$\Delta$ modulator D$\Sigma\Delta$M on the other hand. The circuit 2' of the invention is produced by means of few elements in an economical way.

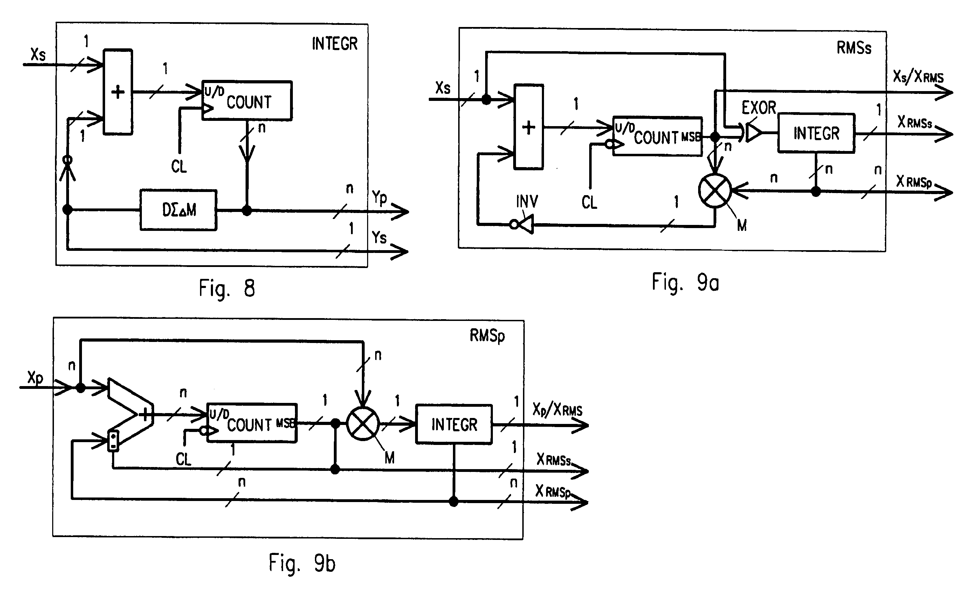

The integrating circuit 3, 4 of the invention is represented in Fig. 8 as a circuit INTEGR. A serial input signal Xs is conducted to the input of a circuit, said input being at the first input of an adder, to the second input of which the output of a digital $\Sigma$-$\Delta$ modulator D$\Sigma\Delta$M and the output for a serial integrated signal Ys are connected. The adder output is connected to the input of an up/down counter COUNT. Its output is the ouput for the parallel integrated signal Yp, which was decimated with a frequency equal to or higher than the frequency of sampling and was interpolated, too, on the one hand and is connected to the input of the digital $\Sigma$-$\Delta$ modulator D$\Sigma\Delta$M on the other hand.

The circuit 14, 15 of the invention for generating the root-mean-square value from a serial input signal Xs is represented in Fig. 9a as a circuit RMSs. According to the invention one of the factors is normalized, the same procedure being applied also in a circuit as represented in Fig. 9b. The input of said circuit is at the first input of an adder, to the second input of which the output of a digital multiplier M is connected through an inverter INV. The adder output is connected to the input of an up/down counter COUNT, the output of which is the ouput for a signal X/XRMS, which is representative of the normalized value of the serial input signal Xs, on the one hand and is connected to the first input of the digital multiplier M on the other hand and is connected to the first input of an EXOR gate EXOR on the third hand. To the second input thereof said serial input signal Xs is conducted. The output of said EXOR gate is connected to the input of an integrator INTEGR, at the serial output of which a serial signal XRMSs representative of the root-mean-square value of the input signal Xs is delivered. To the parallel output of the integrator INTEGR the ouput for the parallel signal XRMSp representative of the root-mean-square value of the input signal Xs and the second input of said multiplier M are connected.

The circuit 12, 13 for generating a signal representative of the root-mean-square value of an input signal Xp in parallel form is represented in Fig. 9b as a circuit RMSp. The input of said circuit is at the first input of an adder, whereas the parallel output of an integrator INTEGR is connected to the second input whereof and to the ouput of the circuit RMSp for a parallel form of a signal XRMSp representative of the normalized value of the input stream. The adder output is connected to the input of an up/down cunter COUNT, thee output of which is the ouput for the serial form signal XRNSs representative of the normalized value of the serial input stream Xp on the one hand and is connected to the control input for setting a sign of the second addend in said adder on the other hand and is connected to the first input of said multiplier M on the third hand. To the second input of the multiplier M the input signal Xp is conducted, to its output, the input of the integrator INTEGR is connected.

Unlike the state of the art (Fig. 2a), computation of the root-mean-square value of the input signal according to the invention is performed in a way that the input signal is multiplied by its normalized value according to the expressions (6) and (7) as well as (6') and (7), respectively. The product obtained by said multiplication is accurate in the entire dynamic range. In this way the circuit RMSs (Fig. 9a) reaches satisfactory accuracy in the dynamic range 1:10, thus meeting demands for the processing of voltage signals. To process current signals the circuit RMSp (Fig. 9b) must be applied, whereby satisfactory accuracy in the dynamic range 1:1000 is reached and therefore no higher resolution of the input $\Sigma$-$\Delta$ modulator 1 is needed.

Fig. 11 shows a circuit of the invention in the second variant embodiment for generating signals representative of the electric power parameters. Through a first decimation circuit 3a and a second decimation circuit 3b said first order $\Sigma$-$\Delta$ modulators 1a and 2a, respectively, are connected to the inputs of a digital signal processor 5a (DSP). At the output of the digital signal processor 5a a signal Ppar representative of any of electric power parameters like an actual power signal P, a reactive power signal Q, an apparent power signal S, a signal i/I representative of the normalized value of the electric current intensity and a signal u/U representative of the normalized value of the electric voltage or a phase angle cosine signal cos$\Phi$ is delivered.

The digital signal processor 5a computes the data stream for the signal Ppar from both input data streams, in fact, for the case of the first input analogue measuring signal in the first form, from the aforesaid expressions (1) to (7) and, for the case of the first input analogue measuring signal in the second form, from the aforesaid expressions (1'), (2'), (4')-(6') and (7).

The proposed way of processing signals in the first as well in the second variant embodiments for generating signals representative of electric power parameters is adapted to be designed in microelectronic technologies FPGA and ASIC.

**Claims**

1. Circuit for generating signals representative of electric power parameters by digitally processing a first input analogue measuring signal in a first form as a signal di/dt representative of a time derivative of the electric current intensity or in a second form as a signal i representative of the electric current intensity and a second input analogue measuring signal u as a signal representative of the electric voltage,
   in that the first input analogue measuring signal is conducted to the input of a first $\Sigma$-$\Delta$ modulator (1) and the second input analogue measuring signal is conducted to the input of a second $\Sigma$-$\Delta$ modulator (2) and one-bit data streams corresponding to the first and second input analogue measuring signal are delivered by said first and second $\Sigma$-$\Delta$ modulator (1, 2), respectively,
   **characterized in**
   **that** the one-bit data stream from the output of the second $\Sigma$-$\Delta$ modulator (2) is conducted to the first input of a multiplexer (2") and to the input of a circuit (2') for time derivating and decimating, the time-drivative output of which is connected to the second input of the multiplexer (2"), at the output of which, in the case of the first input analogue measuring signal in the first form, the data stream as delivered at the output of the second Σ-Δ modulator (2) is delivered and, in the case of the first input analogue measuring signal in the second form, the data stream as delivered at the time-drivative output of the circuit (2') for time derivating and decimating is delivered,

**that** the output of the first Σ-Δ modulator (1) is connected to the first input of a first multiplier (5), to the second input of which the decimating output of the circuit (2') for time derivating and decimating is connected and the output of which is connected to the first input of a first adder (7), and

the parallel output of a first integrator (3), which integrator (3) is connected to the output of the first Σ-Δ modulator (1), is connected to the first input of a second multiplier (6), to the second input of which the serial output of a second integrator (4) is connected, whereas said integrator (4) is connected to the output of the multiplexer (2"), and the output of which multiplier (6) is connected to the second input of the first adder (7),

at the output (C) of which first adder (7), in the case of the first input analogue measuring signal in the first form, a reactive power signal Q appears,

**that** through a first inverter (8') the output of the first Σ-Δ modulator (1) is connected to the first input of a third multiplier (8), to the second input of which the parallel output of the second integrator (4) is connected and the output of which is connected to the first input of a second adder (10), and

the parallel output of the first integrator (3) is connected to the first input of a fourth multiplier (9), to the second input of which multiplier (9) the output of the multiplexer (2") is connected and the output of said multiplier (9) is connected to the second input of the second adder (10),

at the output (A) of which second adder (10) an actual power signal P appears,

**that** through a second inverter (11') the output of the third multiplier (8) is connected to the first input of a third adder (11), to the second input of which the output of the fourth multiplier (9) is connected and the output of said adder (11) is connected to the input of a first circuit (12) for generating the root-mean-square value,

at the output (B) of said circuit (12) an apparent power signal S appears,

**that** at the output (F) of a second circuit (13) for generating the root-mean-square value, the input of said circuit (13) is connected to the output of the first integrator (3), an electric current root-mean-square value signal I appears,

**that**, in the case of the first input analogue measuring signal in the first form, a signal U representative of the root-mean-square value of the electric voltage appears at the parallel output (G) of a third circuit (14) for generating the root-mean-square value, the input of said circuit (14) is connected to the output of the multiplexer (2"), and, in the case of the first input analogue measuring signal in the second form, a signal U representative of the electric voltage appears at the parallel output (H) of a fourth circuit (15) for generating the root-mean-square value, the input of said circuit (15) is connected to the serial output of the second integrator (4),

**that** the output of the first integrator (3) is connected to the first input of the fifth multiplier (16), to the second input of which the serial output of the fourth circuit (15) for generating the root-mean-square value is connected and the output of which is connected to the first input of a sixth multiplier (17), to the second input of which the serial output of the third circuit (14) for generating the root-mean-square value is connected and

at the output (D) of which a reactive power signal Q appears,

and **that** the signals i/I and u/U representative of the normalized values of the current and voltage, respectively, from the circuit (13) and (14), respectively, for generating the root-mean-square value are conducted to the inputs of an EXOR gate (18),

at thee output (E) of which a signal cosΦ representative of the phase angle cosine appears.

2. Circuit for generating signals representative of electric power parameters as recited in claim 1, **characterized in that** the Σ-Δ modulators (1, 2) are first order modulators.

3. Circuit for generating signals representative of electric power parameters as recited in claim 2, **characterized in that** the circuit (2'; DIFER_DECIM) for time derivating and decimating is made in a way that its input is on the first input of an adder, to the second input of which the output of a digital Σ-Δ modulator (DΣΔM) is connected and the output of which is connected to the input of a first up/down counter (COUNT 1), the output of which is the ouput for the time derivative of the input signal on the one hand and is connected to the input of a second up/down counter (COUNT2) on the other hand, the output of which is the ouput for the decimated input data stream on the one hand and is connected to the input of the digital Σ-Δ modulator (DΣΔM) on the other hand.

4. Circuit for generating signals representative of electric power parameters as recited in any of the previous claims, **characterized in that** the integrator (3, 4; INTEGR) is made in a way that its input is on the first input of an adder, to the second input of which the output of a digital Σ-Δ modulator (DΣΔM) and the output for the integrated signal in the serial form are connected and the output of which is connected to the input of an up/down cunter (COUNT), said output is the ouput for the integrated signal in the parallel form on the one hand and is connected to the input of the digital Σ-Δ modulator (DΣΔM) on the other hand.

**5.** Circuit for generating signals representative of electric power parameters as recited in any of the previous claims, **characterized in**
**that** the circuit (14, 15; RMSs) for generating the signal representative of the root-mean-square value of the input stream in the serial form is made in a way that its input is on the first input of an adder, to said second input through an inverter (INV) the output of a digital multiplier (M) is connected and said output is connected to the input of an up/down counter (COUNT), said output is the output for the normalized value of the serial input stream on the one hand and the first input of the digital multiplier (M) on the other hand and the first input of an EXOR gate (EXOR) on the third hand, to the second input of which said serial input stream is conducted and the output of which is connected to the input of an integrator (INTEGR), at the serial output of which a serial signal representative of the root-mean-square value of the input stream is delivered and the parallel output of which is the ouput for the parallel signal representative of the root-mean-square value of the input data stream on the one hand and is connected to the second input of said multiplier (M) on the other hand.

**6.** Circuit for generating signals representative of electric power parameters as recited in any of the previous claims, **characterized in**
**that** the circuit (12, 13; RMSp) for generating the signal representative of the root-mean-square value of the input stream in the parallel form is made in a way that its input is on the first input of an adder, to the second input of which and to the ouput of the parallel signal representative of the normalized value of the input stream the parallel output of an integrator (INTEGR) is connected and said output is connected to the input of an up/down cunter (COUNT), said output is the ouput for the serial form signal representative of the normalized value of the input stream on the one hand and is connected to the control input for setting a sign of the second addend in said adder on the other hand and is connected to the first input of said multiplier (M) on the third hand, to said second input the input stream is conducted and said output is connected to the input of the integrator (INTEGR).

**7.** Circuit for generating signals representative of electric power parameters by digitally processing a first input analogue measuring signal in a first form as a signal di/dt representative of a time derivative of the electric current intensity or in a second form as a signal i representative of the electric current intensity and of a second input analogue measuring signal u as a signal representative of the electric voltage,
in that the first input analogue measuring signal is conducted to the input of a first Σ-Δ modulator (1a) and the second input analogue measuring signal is conducted to the input of a second Σ-Δ modulator (2a) and one-bit data streams corresponding to the first and second input analogue measuring signal are delivered by said first and second Σ-Δ modulator (1, 2), respectively,
**characterized in**
**that** said one-bit data streams are conducted through a first decimating circuit (3a) and a second decimating circuit (4a), respectively, to the inputs of a digital signal processor (5a), at the output of which a signal Ppar representative of any of the electric power parameters like actual power signal P, reactive power signal Q, apparent power signal S, signal i/I representative of the normalized value of the electric current intensity, signal u/U representative of the normalized value of the electric voltage or phase angle cosine signal cosΦ, is delivered,
in that, for the case of the first input analogue measuring signal in the first form, from both input data streams the digital signal processor (5a) is adapted to compute the data stream representative of the signal Ppar according to the following expressions:

$$P = i \cdot u - \int u \cdot dt \cdot \left( \frac{di}{dt} \right) \qquad (1)$$

$$S = \left( \overline{\left\{ i \cdot u - u \cdot dt \cdot \left( \frac{di}{dt} \right) \right\}^2} \right)^{\frac{1}{2}} \qquad (2)$$

$$Q = K1 \cdot i \cdot \int u \cdot dt \; + K2 \cdot \left( u \cdot \left( \frac{di}{dt} \right) \right) \qquad (3)$$

(K1 and K2 being adjustable constants)

$$Q = i \cdot \frac{\int u \cdot dt}{U} \cdot U \qquad (4)$$

$$\cos\varphi = \frac{u}{U} \cdot \frac{i}{I} \qquad (5)$$

$$I = \frac{\overline{\int \frac{di}{dt} \cdot dt}}{I} \cdot i \qquad (6)$$

$$U = \frac{\overline{u}}{U} \cdot u \qquad (7)$$

and, for the case of the first input analogue measuring signal in the second form, according to the following expressions:

$$P = i \cdot u - \int i \cdot dt \; \cdot \frac{du}{dt} \qquad (1')$$

$$S = \left( \left\{ \overline{\left\{ i \cdot u - i \cdot dt \; \cdot \frac{du}{dt} \right\}^2} \right\} \right)^{\frac{1}{2}} \qquad (2')$$

$$Q = \int i \cdot dt \; \cdot \frac{u}{U} \cdot \frac{du}{dt} \qquad (4')$$

$$\cos\varphi = \frac{\int i \cdot dt}{I} \cdot \frac{\frac{du}{dt}}{U} \qquad (5')$$

$$I = \frac{\overline{i}}{I} \cdot i \qquad (6')$$

$$U = \overline{\frac{u}{U} \cdot u} \quad . \tag{7}$$

8. Circuit for generating signals representative of electric power parameters as recited in claim 7, **characterized in that** the $\Sigma$-$\Delta$ modulators (1a, 2a) are first order modulators.

**Patentansprüche**

1. Schaltung zum Generieren von elektrische Leistung darstellenden Signalen durch digitale Bearbeitung eines ersten analogen Eingangsmeßsignales in einer ersten Form als eines eine zeitliche Ableitung der elektrischen Stromstärke darstellenden Signales di/dt oder in einer zweiten Form als eines die elektrische Stromstärke darstellenden Signales i und
eines zweiten analogen Eingangsmeßsignales als eines die elektrische Spannung darstellenden Signales u,
indem das erste Analogmeßsignal zum Eingang eines ersten $\Sigma$-$\Delta$ Modulators (1) und
das zweite Analogmeßsignal zum Eingang eines zweiten $\Sigma$-$\Delta$ Modulators (2) geleitet werden und
die genannten $\Sigma$-$\Delta$ Modulatoren (1, 2) dem ersten analogen Eingangsmeßsignal beziehungsweise dem zweiten analogen Eingangsmeßsignal entsprechende Einzelbit-Datenströme liefern,
**dadurch gekennzeichnet,**
**daß** der Einzelbit-Datenstrom vom Ausgang des zweiten $\Sigma$-$\Delta$ Modulators (2) an den ersten Eingang eines Multiplexers (2") und an den Eingang einer Schaltung (2') zur zeitlichen Ableitung und Dezimierung geleitet wird,
deren Ausgang für die zeitliche Ableitung an den zweiten Eingang des Multiplexers (2") angeschlossen ist,
an dessen Ausgang im Fall des ersten analogen Eingangsmeßsignales in der ersten Form der Ausgangsdatenstrom des zweiten $\Sigma$-$\Delta$ Modulators (2) geliefert wird und
im Fall des ersten analogen Eingangsmeßsignales in der zweiten Form der Datenstrom vom Ausgang für die zeitliche Ableitung der Schaltung (2') zur zeitlichen Ableitung und Dezimierung geliefert wird,
**daß** der Ausgang des ersten $\Sigma$-$\Delta$ Modulators (1) an den ersten Eingang einer ersten Multiplizierschaltung (5) angeschlossen ist,
an dessen zweiten Eingang der Ausgang für den dezimierten Datenstrom der Schaltung (2') zur zeitlichen Ableitung und Dezimierung angeschlossen ist und
dessen Ausgang an den ersten Eingang eines ersten Addierers (7) angeschlossen ist, und
der Parallelausgang eines ersten Integrators (3), der an den Ausgang des ersten $\Sigma$-$\Delta$ Modulators (1) angeschlossen ist, an den ersten Eingang einer zweiten Multiplizierschaltung (6) angeschlossen ist,
an deren zweiten Eingang der serielle Ausgang eines zweiten Integrators (4) angeschlossen ist, der an den Ausgang des Multiplexers (2") angeschlossen ist, und deren Ausgang an den zweiten Eingang des ersten Addierers (7) angeschlossen ist,
an dessen Augang (C) im Fall des ersten analogen Eingangsmeßsignales in der ersten Form ein Signal Q der Blindleistung erscheint,
**daß** der Ausgang des ersten $\Sigma$-$\Delta$ Modulators (1) über einen ersten Inverter (8') an den ersten Eingang einer dritten Multiplizierschaltung (8) angeschlossen ist,
an deren zweiten Eingang der parallele Ausgang des zweiten Integrators (4) angeschlossen ist und
deren Ausgang an den ersten Eingang eines zweiten Addierers (10) angeschlossen ist, und
der Parallelausgang des ersten Integrators (3) an den ersten Eingang einer vierten Multiplizierschaltung (9) angeschlossen ist,
an deren zweiten Eingang der Ausgang des Multiplexers (2") und
deren Ausgang an den zweiten Eingang des zweiten Addierers (10) angeschlossen ist, an dessen Augang (A) ein Signal P der Effektivleistung erscheint,
**daß** der Ausgang der dritten Multiplizierschaltung (8) über einen zweiten Inverter (11') an den ersten Eingang eines dritten Addierers (11) angeschlossen ist,
an dessen zweiten Ausgang der Ausgang der vierten Multiplizierschaltung (9) angeschlossen ist und
dessen Ausgang an den Eingang einer ersten Schaltung (12) zur Bildung des Effektivwertes angeschlossen ist,
an deren Augang (B) ein Signal S der Scheinleistung erscheint,
**daß** an dem Ausgang (F) einer zweiten Schaltung (13) zur Bildung des Effektivwertes, deren Eingang an den Ausgang des ersten Inegrators (3) angeschlossen ist, ein Signal I des Effektivwertes der Stromstärke erscheint,
**daß** im Fall des ersten analogen Eingangsmeßsignals in der ersten Form am Parallelausgang (G) einer dritten Schaltung (14) zur Bildung des Effektivwertes, deren Eingang an den Ausgang des Multiplexers (2") angeschlossen ist, ein Signal U des Effektivwertes der elektrischen Spannung erscheint

und im Fall des ersten analogen Eingangsmeßsignals in der zweiten Form am Parallelausgang (H) einer vierten Schaltung (15) zur Bildung des Effektivwertes, deren Eingang an den seriellen Ausgang des zweiten Integrators (4) angeschlossen ist, ein Signal U der elektrischen Spannung erscheint

**daß** der Ausgang des ersten Integrators (3) an den ersten Eingang einer fünften Multiplizierschaltung (16) angeschlossen ist,

an deren zweiten Eingang der serielle Ausgang der vierten Schaltung (15) zur Bildung des Effektivwertes angeschlossen ist und

deren Ausgang and den ersten Eingang einer sechsten Multiplizierschaltung (17) angeschlossen ist,

an deren zweiten Eingang der serielle Ausgang der dritten Schaltung (14) zur Bildung des Effektivwertes und

an deren Ausgang (D) ein Signal Q der Blindleistung erscheint,

und **daß** Signale i/I und u/U der normierten Werte der Stromstärke beziehungsweise der Spannung aus der Schaltung (13) beziehungsweise (14) zur Bildung des Effektivwertes an die Eingänge des EXOR-Tores (18) geleitet werden,

an dessen Ausgang (E) ein Signal cosΦ für den Kosinus des Phasenwinkels erscheint.

2. Schaltung zum Generieren von Parameter der elektrischen Leistung darstellenden Signalen nach Anspruch 1, **dadurch gekennzeichnet,**

**daß** Σ-Δ Modulatoren (1, 2) Modulatoren erster Ordnung sind.

3. Schaltung zum Generieren von Parameter der elektrischen Leistung darstellenden Signalen nach Anspruch 2, **dadurch gekennzeichnet,**

**daß** die Schaltung (2'; DIFER_DECIM) zur zeitlichen Ableitung und Dezimierung so hergestellt ist,

**daß** ihr Eingang am ersten Eingang eines Addierers ist,

an deren zweiten Eingang der Ausgang eines digitalen Σ-Δ Modulators (DΣΔM) angeschlosen ist und

deren Ausgang an den Eingang eines ersten Vorwärts-Rückwärtszählers (COUNT1) angeschlossen ist,

dessen Ausgang einerseits der Ausgang für die zeitliche Ableitung des Eingangssignales ist und

andererseits an den Eingang eines zweiten Vorwärts-Rückwärtszählers (COUNT2) angeschlossen ist,

dessen Ausgang einerseits ein Ausgang für den dezimierten Eingangsdatenstrom ist und

andererseits an den Eingang des digitalen Σ-Δ Modulators (DΣΔM) angeschlossen ist.

4. Schaltung zum Generieren von Parameter der elektrischen Leistung darstellenden Signalen nach einem der vorangehenden Ansprüche, **dadurch gekennzeichnet,**

**daß** der Integrator (3, 4; INTEGR) so hergestellt ist,

**daß** sein Eingang am ersten Eingang eines Addierers ist,

an dessen zweiten Eingang der Ausgang eines digitalen Σ-Δ Modulators (DΣΔM) und der Ausgang für das integrierte Signal in serieller Form angeschlossen sind und

dessen Ausgang an den Eingang eines ersten Vorwärts-Rückwärtszählers (COUNT) angeschlossen ist,

dessen Ausgang einerseits der Ausgang für das integrierte Signal in paralleler Form ist und

andererseits an den Eingang des digitalen Σ-Δ Modulators (DΣΔM) angeschlossen ist.

5. Schaltung zum Generieren von Parameter der elektrischen Leistung darstellenden Signalen nach einem der vorangehenden Ansprüche,

**dadurch gekennzeichnet,**

**daß** die Schaltung (14, 15; RMSs) zur Bildung des Signals des Effektivwertes des Eingangsstromes in serieller Form so hergestellt ist,

**daß** ihr Eingang am ersten Eingang eines Addierers ist,

an dessen zweiten Eingang über einen Inverter (INV) der Ausgang einer digitalen Multiplizierschaltung (M) angeschlossen ist und der genannte Ausgang an den Eingang des Vorwärts-Rückwärtszählers (COUNT) angeschlossen ist und

der genannte Ausgang einerseits der Ausgang für den normierten Wert des seriellen Eingangsstromes ist und andererseits der erste Eingang der digitalen Multiplizierschaltung (M) ist und drittenseits der erste Eingang des EXOR Tores (EXOR) ist,

an dessen zweiten Eingang der genannte serielle Eingangsstrom geleitet wird und dessen Ausgang an den Eingang des Integrators (INTEGR) angeschlossen ist,

an dessen seriellen Ausgang ein Signal des Effektivwertes des Eingangsstromes in serieller Form geliefert wird und dessen paralleler Ausgang einerseits der Ausgang für das parallele Signal des Effektivwertes des Eingangsstromes ist und
andererseits an den zweiten Eingang der genannten Multiplizierschaltung (M) angeschlossen ist.

6. Schaltung zum Generieren von Parameter der elektrischen Leistung darstellenden Signalen nach einem der vorangehenden Ansprüche,
**dadurch gekennzeichnet,**
**daß** die Schaltung (12, 13; RMSp) zur Bildung eines Signals des Effektivwertes des Eingangsstromes in paralleler Form so hergestellt ist,
**daß** ihr Eingang am ersten Eingang eines Addierers ist,
an dessen zweiten Eingang und an den Ausgang für das parallele Signal des Effektivwertes des Eingangsstromes der parallele Ausgang des Integrators (INTEGR) angeschlossen ist und
der genannte Ausgang an den Eingang des Vorwärts-Rückwärtszählers (COUNT) angeschlossen ist,
der genannte Ausgang einerseits der Ausgang für die serielle Form des Signals des normierten Wertes des Eingangsstromes ist und
andererseits an den Steuereingang für die Einstellung des Vorzeichens des zweiten der Summanden im genannten Addierer und drittenseits an den ersten Eingang der genannten Multiplizierschaltung (M) angeschlossen ist,
an dessen zweiten Eingang der Eingangsstrom geleitet wird und
der genannte Ausgang an den Eingang des Integrators (INTEGR) angeschlossen ist.

7. Schaltung zum Generieren von Parameter der elektrischen Leistung darstellenden Signalen durch digitale Bearbeitung
eines ersten analogen Eingangsmeßsignals in einer ersten Form als eines eine zeitliche Ableitung der elektrischen Stromstärke darstellenden Signals di/dt oder in einer zweiten Form als eines die elektrische Stromstärke darstellenden Signals i und
eines zweiten analogen Eingangsmeßsignals als eines die elektrische Spannung darstellenden Signals u,
indem das erste Analogmeßsignal zum Eingang eines ersten $\Sigma$-$\Delta$ Modulators (1a) und das zweite Analogmeßsignal zum Eingang eines zweiten $\Sigma$-$\Delta$ Modulators (2a) geleitet werden und
die genannten $\Sigma$-$\Delta$ Modulatoren (1, 2) dem ersten analogen Eingangsmeßsignal beziehungsweise dem zweiten analogen Eingangsmeßsignal entsprechende Einzelbit-Datenströme liefern,
**dadurch gekennzeichnet,**
**daß** die genannten Einzelbit-Datenströme über eine erste Dezimierschaltung (3a) beziehungsweise eine zweite Dezimierschaltung (4a) an die Eingänge eines digitalen Signalprozessors (5a) geleitet werden,
an dessen Ausgang ein Signal Ppar für irgendeinen Parameter der elektrischen Leistung wie das Signal P der Effektivleistung, das Signal Q der Blindleistung, das Signal S der Scheinleistung, das Signal i/I des normierten Wertes der Stromstärke beziehungsweise das Signal u/U des normierten Wertes der elektrischen Spannung oder das Signal cos$\Phi$ für den Kosinus des Phasenwinkels erscheint,
indem der digitale Signalprozessor (5a) angepaßt ist, aus beiden Eingangsdatenströmen den Datenstrom des Signals Ppar
für den Fall des ersten analogen Eingangsmeßsignals in der ersten Form aus folgenden Ausdrücken auszurechnen:

$$P = i \cdot u - \left( \int u \cdot dt \right) \cdot \left( \frac{di}{dt} \right) \tag{1}$$

$$S = \left( \overline{\left\{ (i \cdot u) - (u \cdot dt) \cdot \left( \frac{di}{dt} \right) \right\}^2} \right)^{\frac{1}{2}} \tag{2}$$

$$Q = K1 \cdot \left( i \cdot \left( \int u \cdot dt \right) \right) + K2 \cdot \left( u \cdot \left( \frac{di}{dt} \right) \right) \tag{3}$$

(K1 und K2 sind anpassbare Konstanten)

$$Q = i \cdot \frac{\int u \cdot dt}{U} \cdot U \tag{4}$$

$$\cos\phi = \frac{u}{U} \cdot \frac{i}{I} \tag{5}$$

$$I = \frac{\overline{\int \frac{di}{dt} \cdot dt}}{I} \cdot i \tag{6}$$

$$U = \frac{\overline{u}}{U} \cdot u \tag{7}$$

und für den Fall des ersten analogen Eingangsmeßsignales in der zweiten Form aus folgenden Ausdrücken auszurechnen:

$$P = i \cdot u - \left(\int i \cdot dt\right) \cdot \frac{du}{dt} \tag{1'}$$

$$S = \left(\overline{\left\{i \cdot u - (i \cdot dt) \cdot \frac{du}{dt}\right\}^2}\right)^{\frac{1}{2}} \tag{2'}$$

$$Q = \left(\int i \cdot dt\right) \cdot \frac{u}{U} \cdot \frac{du}{dt} \tag{4'}$$

$$\cos\phi = \frac{\int i \cdot dt}{I} \cdot \frac{\frac{du}{dt}}{U} \tag{5'}$$

$$I = \frac{\overline{i}}{I} \cdot i \tag{6'}$$

$$U = \frac{\overline{u}}{U} \cdot u \quad . \tag{7}$$

8. Schaltung zum Generieren von Parameter der elektrischen Leistung darstellenden Signalen nach Anspruch 7, **dadurch gekennzeichnet,** **daß** die $\Sigma$-$\Delta$ Modulatoren (1a, 2a) Modulatoren erster Ordnung sind.

## Revendications

1. Circuit destiné à produire des signaux représentatifs de paramètres de puissance électrique en traitant de façon numérique un premier signal de mesure analogique en entrée sous une première forme comme un signal di/dt représentatif d'une dérivée de l'intensité de courant électrique par rapport au temps ou sous une deuxième forme comme un signal i représentatif de l'intensité du courant électrique ainsi qu'un deuxième signal u de mesure analogique en entrée comme un signal représentatif de la tension électrique,

   dans lequel le premier signal de mesure analogique en entrée est conduit à l'entrée d'un premier modulateur (1) $\Sigma$-$\Delta$ et le deuxième signal de mesure analogique en entrée est conduit à l'entrée d'un deuxième modulateur (2) $\Sigma$-$\Delta$ et des flux de données à un bit correspondant au premier et au deuxième signal de mesure analogique en entrée sont délivrés par lesdits premier et deuxième modulateurs (1, 2) $\Sigma$-$\Delta$, respectivement,

   **caractérisé**

   **en ce que** le flux de données à 1 bit en provenance de la sortie du deuxième modulateur (2) $\Sigma$-$\Delta$ est conduit à la première entrée d'un multiplexeur (2") ainsi qu'à l'entrée d'un circuit (2') destiné à une dérivation par rapport au temps et à une décimation, dont la sortie de dérivée par rapport au temps est raccordée à la deuxième entrée du multiplexeur (2"), à la sortie duquel, dans le cas où le premier signal de mesure analogique en entrée est sous la première forme, le flux de données tel que délivré à la sortie du deuxième modulateur (2) $\Sigma$-$\Delta$ est délivré et, dans le cas où le premier signal de mesure analogique en entrée est sous la deuxième forme, le flux de données tel que délivré à la sortie de dérivée par rapport au temps du circuit (2') pour dérivation par rapport au temps et décimation est délivré,

   **en ce que** la sortie du premier modulateur (1) $\Sigma$-$\triangle$ est raccordée à la première entrée d'un premier multiplieur (5), à la deuxième entrée duquel est raccordée la sortie de décimation du circuit (2') pour dérivation par rapport au temps et décimation et dont la sortie est raccordée à la première entrée d'un premier additionneur (7), et

   la sortie parallèle d'un premier intégrateur (3), lequel intégrateur (3) est raccordé à la sortie du premier modulateur (1) $\Sigma$-$\Delta$, est raccordée à la première entrée d'un deuxième multiplieur (6), à la deuxième entrée duquel est raccordée la sortie série d'un deuxième intégrateur (4), tandis que ledit intégrateur (4) est raccordé à la sortie du multiplexeur (2"), et la sortie du multiplieur (6) en question est raccordée à la deuxième entrée du premier additionneur (7),

   à la sortie (C) du premier additionneur (7) en question, dans le cas où le premier signal de mesure analogique en entrée est sous la première forme, apparaît un signal Q de puissance réactive,

   **en ce qu'**à travers un premier inverseur (8') la sortie du premier modulateur (1) $\Sigma$-$\Delta$ est raccordée à la première entrée d'un troisième multiplieur (8), à la deuxième entrée duquel est raccordée la sortie parallèle du deuxième intégrateur (4) et dont la sortie est raccordée à la première entrée d'un deuxième additionneur (10), et

   la sortie parallèle du premier intégrateur (3) est raccordée à la première entrée d'un quatrième multiplieur (9), à la deuxième entrée du multiplieur (9) en question est raccordée la sortie du multiplexeur (2") et la sortie dudit multiplieur (9) est raccordée à la deuxième entrée du deuxième additionneur (10),

   à la sortie (A) du deuxième additionneur (10) en question apparaît un signal P de puissance réelle,

   **en ce qu'**à travers un deuxième inverseur (11'), la sortie du troisième multiplieur (8) est raccordée à la première entrée d'un troisième additionneur (11), à la deuxième entrée duquel est raccordée la sortie du quatrième multiplieur (9) et la sortie dudit additionneur (11) est raccordée à l'entrée d'un premier circuit (12) destiné à produire une valeur quadratique moyenne,

   à la sortie (B) dudit circuit (12) apparaît un signal S de puissance apparente,

   **en ce qu'**à la sortie (F) d'un deuxième circuit (13) destiné à produire la valeur quadratique moyenne, l'entrée dudit circuit (13) est raccordée à la sortie du premier intégrateur (3), un signal I de valeur quadratique moyenne de courant électrique apparaît,

   **en ce que**, dans le cas où le premier signal de mesure analogique en entrée est sous la première forme, un signal U représentatif de la valeur quadratique moyenne de la tension électrique apparaît à la sortie (G) parallèle d'un troisième circuit (14) destiné à produire la valeur quadratique moyenne, l'entrée dudit circuit (14) est raccordée à la sortie du multiplexeur (2"), et, dans le cas où le premier signal de mesure analogique en entrée est sous la seconde forme, un signal U représentatif de la tension électrique apparaît à la sortie (H) parallèle d'un quatrième circuit (15) destiné à produire la valeur quadratique moyenne, l'entrée dudit circuit (15) est raccordée à la sortie série du deuxième intégrateur (4),

   **en ce que** la sortie du premier intégrateur (3) est raccordée à la première entrée du cinquième multiplieur (16), à la deuxième entrée duquel est raccordée la sortie série du quatrième circuit (15) destiné à produire la valeur quadratique moyenne et dont la sortie est raccordée à la première entrée d'un sixième multiplieur (17), à la deuxième entrée duquel est raccordée la sortie série du troisième circuit (14) destiné à produire la valeur quadratique moyenne et

   à la sortie (D) duquel apparaît un signal Q de puissance réactive,

   et **en ce que** les signaux i/I et u/U représentatifs des valeurs normalisées du courant et de la tension, respectivement, en provenance du circuit (13) et (14), respectivement, destinés à produire la valeur quadratique moyenne sont conduits aux entrées d'une porte (18) OU exclusif,

à la sortie (E) duquel apparaît un signal cosΦ représentatif du cosinus d'angle de phase.

2. Circuit destiné à produire des signaux représentatifs de paramètres de puissance électrique selon la revendication 1, **caractérisé**

   **en ce que** les modulateurs (1, 2) Σ-Δ sont des modulateurs de premier ordre.

3. Circuit destiné à produire des signaux représentatifs de paramètres de puissance électrique selon la revendication 2, **caractérisé**

   **en ce que** le circuit (2', DIFER_DECIM) destiné à la dérivation par rapport au temps et à la décimation est réalisé de sorte que son entrée est sur la première entrée d'un additionneur, à la deuxième entrée duquel est raccordée la sortie d'un modulateur Σ-Δ numérique (DΣΔM) et dont la sortie est raccordée à l'entrée d'un premier compteur (COUNT1) vers le haut/vers le bas, dont la sortie est la sortie pour la dérivée par rapport au temps du signal en entrée d'une part et est raccordée à l'entrée d'un deuxième compteur (COUNT2) vers le haut/vers le bas d'autre part, dont la sortie est la sortie pour le flux de données en entrée résultat de la décimation d'une part et est raccordée à l'entrée du modulateur Σ-Δ numérique (DΣΔM) d'autre part.

4. Circuit destiné à produire des signaux représentatifs de paramètres de puissance électrique selon l'une quelconque des revendications précédentes, **caractérisé**

   **en ce que** l'intégrateur (3, 4 ; INTEGR) est réalisé de façon que son entrée est sur la première entrée d'un additionneur, à la deuxième entrée duquel sont raccordées la sortie d'un modulateur Σ-Δ numérique (DΣΔM) ainsi que la sortie pour le signal intégré dans la forme série et dont la sortie est raccordée à l'entrée d'un compteur (COUNT) vers le haut/vers le bas, ladite sortie est la sortie pour le signal intégré sous la forme parallèle d'une part, et est raccordée à l'entrée du modulateur numérique Σ-Δ (DΣΔM) d'autre part.

5. Circuit destiné à produire des signaux représentatifs de paramètres de puissance électrique selon l'une quelconque des revendications précédentes, **caractérisé**

   **en ce que** le circuit (14, 15 ; RMSs) destiné à produire le signal représentatif de la valeur quadratique moyenne du flux d'entrée sous la forme série est réalisé de façon que son entrée est sur la première entrée d'un additionneur, à ladite deuxième entrée est raccordée à travers un inverseur (INV) la sortie d'un multiplieur (M) numérique et ladite sortie est raccordée à l'entrée d'un compteur (COUNT) vers le haut/vers le bas, ladite sortie est la sortie pour la valeur normalisée du flux d'entrée série d'une part et la première entrée du multiplieur (M) numérique d'autre part et la première entrée d'une porte ou exclusif (EXOR) par ailleurs, à la deuxième entrée duquel est conduit ledit flux d'entrée série et dont la sortie est raccordée à l'entrée d'un intégrateur (INTEGR), à la sortie série duquel est délivré un signal série représentatif de la valeur quadratique moyenne du flux d'entrée et dont la sortie parallèle est la sortie pour le signal parallèle représentatif de la valeur quadratique moyenne du flux de données en entrée d'une part et est raccordée à la deuxième entrée dudit multiplieur (M) d'autre part.

6. Circuit destiné à produire des signaux représentatifs de paramètres de puissance électrique selon l'une quelconque des revendications précédentes, **caractérisé**

   **en ce que** le circuit (12, 13 ; RMSp) destiné à produire le signal représentatif de la valeur quadratique moyenne du flux d'entrée sous la forme parallèle est réalisé de façon que son entrée est sur la première entrée d'un additionneur, à la deuxième entrée duquel et à la sortie du signal parallèle représentatif de la valeur normalisée du flux d'entrée est raccordée la sortie parallèle d'un intégrateur (INTEGR) et ladite sortie est raccordée à l'entrée d'un compteur (COUNT) vers le haut/vers le bas, ladite sortie est la sortie pour le signal sous la forme série représentatif de la valeur normalisée du flux en entrée d'une part et est raccordée à l'entrée de commande pour établir un signe du deuxième cumulateur dans ledit additionneur d'autre part et est raccordée à la première entrée dudit multiplieur (M) par ailleurs, à ladite deuxième entrée est conduit le flux d'entrée et ladite sortie est raccordée à l'entrée de l'intégrateur (INTEGR).

7. Circuit destiné à produire des signaux représentatifs de paramètres de puissance électrique en traitant de façon numérique un premier signal de mesure analogique en entrée sous une première forme comme un signal di/dt représentatif d'une dérivée par rapport au temps de l'intensité de courant électrique ou sous une deuxième forme comme un signal i représentatif de l'intensité de courant électrique et d'un deuxième signal u de mesure analogique en entrée comme un signal représentatif de la tension électrique,

   dans lequel le premier signal de mesure analogique en entrée est conduit à l'entrée d'un premier modulateur (1a) Σ-Δ et le deuxième signal de mesure analogique en entrée est conduit à l'entrée d'un deuxième modulateur (2a) Σ-Δ et des flux de données à un bit correspondant au premier et au deuxième signal de mesure analogique en entrée sont délivrés par lesdits premier et deuxième modulateurs (1, 2) Σ-Δ, respectivement,
**caractérisé**
**en ce que** lesdits flux de données à un bit sont conduits à travers un premier circuit (3a) de décimation ainsi qu'un deuxième circuit (4a) de décimation, respectivement, aux entrées d'un processeur (5a) de signal numérique, à la sortie duquel est délivré un signal Ppar représentatif de l'un quelconque des paramètres de puissance électrique comme un signal P de puissance réelle, un signal Q de puissance réactive, un signal S de puissance apparente, un signal i/I représentatif de la valeur normalisée de l'intensité de courant électrique, un signal u/U représentatif de la valeur normalisée de la tension électrique ou un signal cosΦ de cosinus d'angle de phase,

dans lequel, dans le cas où le premier signal de mesure analogique en entrée est sous la première forme, à partir des deux flux de données en entrée, le processeur (5a) de signal numérique est adapté à calculer le flux de données représentatif du signal Ppar conformément aux expressions suivantes :

$$P = i \cdot u - \int u \cdot dt \cdot \left( \frac{di}{dt} \right) \qquad (1)$$

$$S = \left( \left\{ \left( i \cdot u - u \cdot dt \cdot \left( \frac{di}{dt} \right) \right)^2 \right\} \right)^{\frac{1}{2}} \qquad (2)$$

$$Q = K1 \cdot i \cdot \int u \cdot dt + K2 \cdot \left( u \cdot \left( \frac{di}{dt} \right) \right) \qquad (3)$$

(K1 et K2 étant des constantes réglables)

$$Q = i \cdot \frac{\int u \cdot dt}{U} \cdot U \qquad (4)$$

$$\cos \overline{\Phi} = \frac{u}{U} \cdot \frac{i}{I} \qquad (5)$$

$$I = \frac{\overline{\int \frac{di}{dt} \cdot dt}}{I} \cdot i \qquad (6)$$

$$U = \overline{\frac{u}{U}} \cdot u \qquad (7)$$

et, dans le cas où le premier signal de mesure analogique est sous la deuxième forme, conformément aux expressions suivantes :

$$P = i \cdot u - \int i \cdot dt \cdot \frac{du}{dt} \qquad (1')$$

$$S = \left( \overline{\left\{ i \cdot u - i \cdot dt \cdot \frac{du}{dt} \right\}^2} \right)^{\frac{1}{2}} \qquad (2')$$

$$Q = \int i \cdot dt \cdot \frac{u}{U} \cdot \frac{du}{dt} \qquad (4')$$

$$\cos \vec{\phi} = \frac{\int i \cdot dt}{I} \cdot \frac{\frac{du}{dt}}{U} \qquad (5')$$

$$I = \frac{\overline{i}}{I} \cdot i \qquad (6')$$

$$U = \frac{\overline{u}}{U} \cdot u \quad . \qquad (7')$$

8. Circuit destiné à produire des signaux représentatifs de paramètres de puissance électrique selon la revendication 7, **caractérisé**
**en ce que** les modulateurs (1a, 2a) $\Sigma$-$\Delta$ sont des modulateurs de premier ordre.

Fig. 1

Fig. 2a

Fig. 2b

Fig. 2c

EP 1 378 756 B1

Fig. 3

Fig. 4

Fig. 5

Fig. 6

DIFER_DECIM

Xs

COUNT1

C2

$\dfrac{dXs}{dt}$

24

29

COUNT2

C2

Xp

Fig. 7

Fig. 9a

Fig. 8

Fig. 9b

Fig. 10

EP 1 378 756 B1

23

Fig.11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5862069 A
- US 6278392 B
- EP 0681235 A3
- US 6307493 B
- US 5485393 A
- US 6078870 A
- US 5345409 A
- US 5736848 A

### Non-patent literature cited in the description

- **P. O'LEARY et al.** Bit Stream Adder for Oversampling Coded Data. *Electronics Letters,* 27 September 1990, vol. 26 (20
- **D. A. JOHNS et al.** IIR Filtering on Sigma-Delta Modulated Signals. *Electronics Letters,* 14 February 1991, vol. 27 (4